Europäisches Patentamt

European Patent Office

Office européen des brevets

(11) Numéro de publication: **0 349 364**
**A1**

## DEMANDE DE BREVET EUROPEEN

(21) Numéro de dépôt: **89401646.8**

(22) Date de dépôt: **13.06.89**

(51) Int. Cl.5: **C 30 B 25/12**
**C 30 B 23/02, C 23 C 14/50**

(30) Priorité: **28.06.88 FR 8808667**

(43) Date de publication de la demande:
**03.01.90  Bulletin  90/01**

(84) Etats contractants désignés: **DE GB NL**

(71) Demandeur: **ETAT FRANCAIS représenté par le C.N.E.T.**
**38-40 rue du Général Leclerc**
**F-92131 Issy-les-Moulineaux  (FR)**

(72) Inventeur: **Doue, Julien**
**4, rue de la Campagnarde**
**F-91430 Igny  (FR)**

**Beauvineau, Jacky**
**18 rue des Arts et Métiers**
**F 60140 Liancourt  (FR)**

(74) Mandataire: **Guilguet, Philippe**
**Cabinet ARMENGAUD AINE 3, Avenue Bugeaud**
**F-75116 Paris  (FR)**

(54) **Dispositif de support pour un substrat mince, notamment en un matériau semiconducteur.**

(57) Dispositif de support pour un substrat mince (12), notamment en un matériau semiconducteur se présentant sous la forme d'une plaquette à profil circulaire, comportant une platine munie de butées fixes en saillie (9) contre lesquelles s'appuie le substrat.

Selon l'invention, ce dispositif se caractérise en ce que les butées fixes (9) sont disposées sur la platine (2) de façon à délimiter un logement ouvert 8 dans lequel s'engage librement le substrat (12), la platine comprenant une butée complémentaire mobile (14), propre à s'escamoter dans un évidement (18) prévu dans l'épaisseur de la platine pour permettre l'engagement du substrat, puis après mise en place de celui-ci jusqu'au contact avec les butées fixes, à s'appliquer de façon élastique contre le bord du substrat en le maintenant appliqué contre ces butées.

Application à l'industrie des composants semiconducteurs.

FIG. 3

## Description

## Dispositif de support pour un substrat mince, notamment en un matériau semiconducteur

' La présente invention est relative à un dispositif de support pour une plaquette ou un substrat mince d'un matériau monocristallin semiconducteur, apte à être placé dans une enceinte de chauffage appropriée afin de réaliser sur ce substrat une croissance épitaxiale, de préférence au moyen de jets moléculaires, du même matériau, dopé ou non.

Dans les installations classiques de fabrication des composants semiconducteurs, le substrat à traiter, par épitaxie notamment, est monté à l'intérieur de l'enceinte d'un four de réaction sur un support en graphite ou autre matière, appelé suscepteur, généralement horizontal et sur lequel le substrat est disposé en étant immobilisé par des pions répartis à la périphérie du support. Ces pions présente généralement une tête débordante en appui sur les bords du substrat tandis que les axes de ces pions, après traversée du support, sont arrêtés par des épingles métalliques les traversant latéralement. En variante, les pions peuvent être remplacés par une couronne circulaire venant s'appuyer sur la périphérie du substrat ou encore par une bague visée ou bloquée sur le support par un système à baïonnette ou analogue.

Or, ces solutions présentent des inconvénients du fait notamment que la mise en place du substrat et son immobilisation exigent des opérations relativement longues et délicates, en particulier pour le montage des pions ou de la couronne d'appui. Par ailleurs, avec une bague à baïonnette, le substrat n'est pas parfaitement fixé vis-à-vis du support.

La présente invention concerne un dispositif de support pour un substrat du genre rappelé ci-dessus mais qui évite ces inconvénients, en permettant une mise en place sûre, rapide et efficace, avec une complète immobilisation du substrat. L'invention permet également d'envisager aisément une automatisation des opérations nécessaires à cette mise en place, le substrat étant reçu dans son support de façon toujours identique à elle-même.

A cet effet, le dispositif de support considéré, pour un substrat se présentant sous la forme d'une plaquette mince à profil circulaire, comportant une platine munie de butées fixes en saillie contre lesquelles s'appuie le substrat, les butées fixes étant disposées sur la platine de façon à délimiter un logement ouvert dans lequel s'engage librement le substrat, se caractérise en ce que la platine comprend une butée complémentaire mobile, propre à s'escamoter dans un évidement prévu dans l'épaisseur de la platine pour permettre l'engagement du substrat, puis après mise en place de celui-ci jusqu'au contact avec les butées fixes, à s'appliquer de façon élastique contre le bord du substrat en le maintenant appuyé contre ces butées.

Selon une caractéristique particulière de l'invention, les butées fixes sont réparties sur une face de la platine pour venir en contact avec trois points séparés du substrat, disposés pour deux d'entre eux selon un diamètre du substrat et pour le troisième selon un rayon perpendiculaire à ce diamètre.

Avantageusement, la platine comporte dans son logement ouvert une zone centrale évidée, circulaire, de diamètre légèrement inférieur à celui du substrat, les butées fixes étant constituées par des rebords solidaires de la platine et espacés de la périphérie de la zone centrale, ces rebords comportant chacun une première partie perpendiculaire au plan de la platine et terminée par une seconde partie dirigée vers le centre de la zone centrale pour s'étendre partie dirigée vers le centre de la zone centrale pour s'étendre parallèlement au plan du substrat de telle sorte que celui-ci, lors de sa mise en place sur la platine soit disposé au-dessus de la zone centrale avec son bord engagé sous les rebords des butées fixes.

Selon une autre caractéristique particulière du dispositif, chaque rebord d'une butée fixe délimite entre sa seconde partie parallèle au plan de la platine et celle-ci un espace dont la hauteur est sensiblement égale à l'épaisseur du substrat.

De préférence, la butée complémentaire est constituée par un pion, comprenant un axe et une tête plate perpendiculaire à cet axe, l'évidement de la platine présentant des dimensions correspondant à celles de la tête du pion pour permettre d'effacer celui-ci dans l'épaisseur de la platine, l'axe du pion traversant librement un passage communiquant avec l'évidement et étant soumis à l'effet d'un ressort qui tend en permanence à exercer sur ce pion un effort repoussant le pion vers l'extérieur de l'évidement en direction du substrat.

Selon une caractéristique additionnelle, l'axe du pion se termine par un épanouissement conique évasé, ménagé à l'oppsé de la tête plate et contre lequel s'appuie le ressort immobilisé contre la platine dans une rainure ouverte prévue dans celle-ci à l'extérieur de l'évidement recevant le pion.

Avantageusement, le ressort présente la forme d'une épingle à cheveux, dont une branche est en appui dans le fond de la rainure et l'autre forme une boucle entourant l'axe du pion.

Enfin, et selon encore une autre caractéristique du dispositif considéré, la platine est de préférence montée sur une embase fixe et bloquée sur celle-ci au moyen d'un ensemble de verrouillage, notamment du genre à baïonnette.

D'autres caractéristiques d'un dispositif de support pour substrat mince selon l'invention, apparaîtront encore à travers la description qui suit d'un exemple de réalisation, donné à titre indicatif et non limitatif, en référence au dessin annexé sur lequel :

- La Figure 1 est une vue en perspective du support considéré.

- Les Figures 2 et 3 sont des vue en coupe transversale de ce support, illustrant la manière avec laquelle le substrat minceest mis en place sur celui-ci.

- La Figure 4 est une vue de détail à plus grande échelle du support, faisant plus spécialement apparaître les caractéristiques et comprendre le montage du pion d'immobilisation complémentaire.

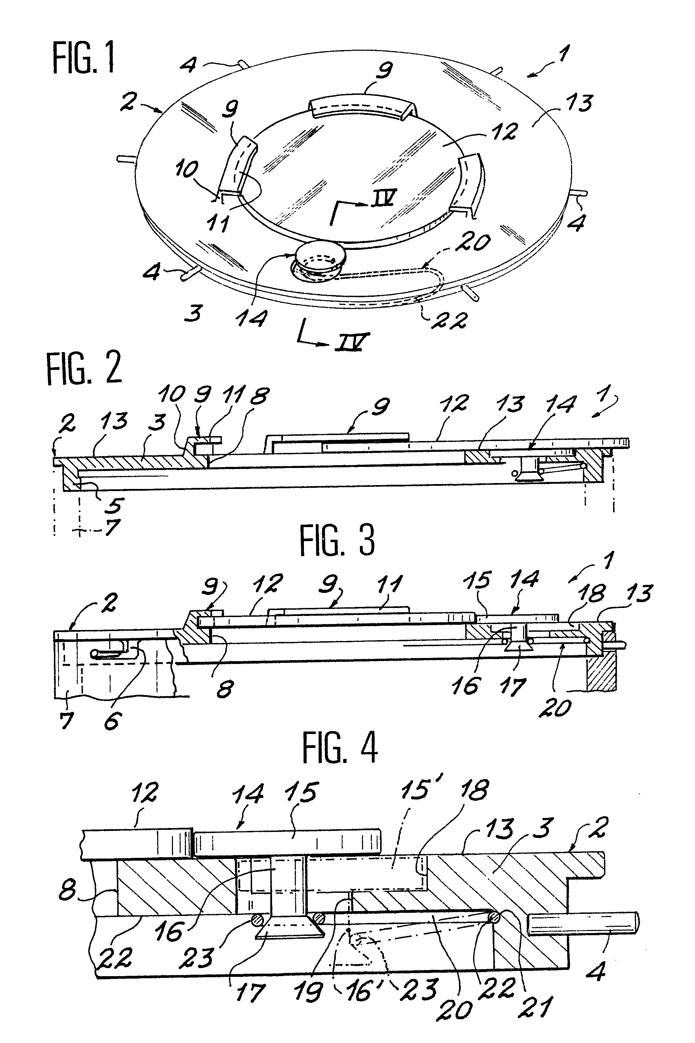

Dans l'exemple de réalisation illustré sur les Figures, la référence 1 désigne dans son ensemble le dispositif de support considéré. Celui-ci comporte une platine 2, présentant un plan d'appui supérieur 3 disposé de préférence horizontalement et comprenant à sa périphérie des doigts radiaux 4 s'étendant à partir d'une collerette 5 ménagée sous le plan 3. Les doigts 4 sont prévus pour coopérer avec des logements 6 formant baïonnette, pour permettre de façon en soi connue, le montage et l'immobilisation de la platine sur une embase 7, schématiquement représentée sur les Figures 2 et 3.

La platine 2 comporte, sensiblement au centre du plan 3, un logement ouvert 8, délimitant une zone centrale de forme circulaire. Elle comporte par ailleurs des butées fixes 9, au nombre de trois dans l'exemple considéré, qui, comme illustré sur la Figure 1, se répartissent autour de la zone centrale du logement 8 en étant pour d'eux d'entre elles diamétralement opposées, la troisième étant espacée des deux précédentes et à égale distance de l'une et de l'autre.

Chaque butée fixe 9 se présente sous la forme d'un rebord ouvert, comprenant une première partie 10 qui s'étend sensiblement verticalement au-dessus du plan 3 et une seconde partie 11 prolongeant la première, en étant disposée parallèlement à ce plan. La platine est prévue pour assurer l'immobilisation d'un substrat se présentant sous la forme d'une plaquette mince circulaire 12, en un matériau semiconducteur approprié, propre à être glissée sur la face supérieure 13 du plan d'appui 3 en venant ainsi s'engager sous la partie supérieure 11 des rebords des butées 9 jusqu'à venir en appui contre les parties 10 de ces derniers. Le diamètre de la plaquette 12 est légèrement supérieur à celui du logement ouvert 8 prévu dans le plan de la platine.

Conformément à l'invention, la plaquette 12 ainsi mise en place est définitivement immobilisée sur la platine au moyen d'un pion complémentaire 14, mobile, monté sur le plan 3 en regard de la troisième butée fixe de l'autre côté du logement 8, ce pion 14 et les trois butées fixes 9 étant ainsi disposés à 90° les uns des autres autour du substrat 12.

Le pion 14 se compose d'une tête plate 15 et d'un axe vertical 16 situé sous cette dernière, l'axe 16 comprenant de préférence un épanouissement terminal 17 de forme légèrement conique et dont le rôle sera précisé ci-après. Le pion 14 est monté mobile à l'intérieur d'un évidement 18, ménagé dans l'épaisseur du plan 3 de la platine, cet évidement présentant une dimension transversale sensiblement égale à celle de la tête 15 du pion. L'évidement 18 se prolonge par un passage 19 (Figure 3) dans lequel passe librement l'axe 16, ce passage ayant cependant une largeur inférieure à celle de la tête 15 pour éviter que le pion ne puisse s'échapper de la platine 2.

Le pion 14 est en permanence soumis à l'effet ressort 20 en épingle à cheveux ainsi que le montre schématiquement la Figure 1. L'une des branches 22 de ce ressort est en appui contre le fond d'une rainure 21 prévue dans la platine 2 sous le plan supérieur 3 de celle-ci, tandis que l'autre branche 23 forme de préférence une boucle entourant l'axe 16 du pion au-dessus de l'épanouissement 17, dont la forme évasée évite ainsi que le ressort ne se libère de cet axe.

L'épanouissement 17 a également pour fonction, en raison de sa forme conique, de faire en sorte que le ressort 20 qui s'applique sur celui-ci, tende constamment à maintenir la tête du pion sur le plan 3 ou sur le fond de l'évidement 18 de la platine 2.

Le fonctionnement du dispositif de support pour substrat mince tel que décrit ci-dessus se déduit aisément de cette description et des Figures du dessin annexé.

La platine 2 étant immobilisée préalablement sur son embase 7, la plaquette mince 12 du substrat est mise en place sous les rebords des butées fixes 9, le pion 14 étant au cours de cette première phase effacé dans l'évidement 18, sa tête 15 affleurant seulement au niveau de la surface 13. Sur la vue de détail de la Figure 4, les références 15' et 16' illustrent notamment la position du pion mobile 14 ainsi engagé dans l'évidement. Une fois la plaquette 12 en appui contre les butées fixes 9, il suffit de libérer le pion 14 qui, sous l'effet du ressort 20, est repoussé vers le haut, la tête plate 15 émergeant au-dessus de la surface 13, en même temps qu'il vient s'appliquer contre le bord de la plaquette 12 en maintenant celle-ci contre la butée fixe en regard.

On réalise ainsi un dispositif de support particulièrement simple dans sa conception et sûr dans son fonctionnement. La mise en place d'une plaquette formant substrat peut être réalisée automatiquement, le pion mobile d'immobilisation venant bloquer la plaquette en position, une fois celle-ci en appui contre les butées fixes qui, en coopération avec le plan supérieur de la platine, assurent une parfaite horizontalité du substrat.

Bien entendu, il va de soi que l'invention ne se limite pas à l'exemple de réalisation plus spécialement décrit et représenté ci-dessus ; elle en embrasse au contraire toutes les variantes.

## Revendications

1 - Dispositif de support pour un substrat mince, notamment en un matériau semiconducteur, se présentant sous la forme d'une plaquette à profil circulaire, comportant une platine munie de butées fixes en saillie contre lesquelles s'appuie le substrat, les butées fixes étant disposées sur la platine de façon à délimiter un logement ouvert (8) dans lequel s'engage librement le substrat (12), caractérisé en ce que la platine (2) comprend une butée complémentaire mobile (14), propre à s'escamoter dans un évidement (18) prévu dans l'épaisseur de la platine pour permettre l'engagement du substrat, puis après mise en place de celui-ci jusqu'au contact avec les butées fixes (9), à s'appliquer de façon élastique contre le bord du substrat en le maintenant appuyé contre ces butées.

2 - Dispositif selon la revendication 1, caractérisé en ce que les butées fixes (9) sont réparties sur une face de la platine afin de venir en contact avec trois points séparés du substrat (12), disposés pour deux d'entre eux selon un diamètre du substrat et pour le troisième selon un rayon perpendiculaire à ce diamètre.

3 - Dispositif selon l'une des revendications 1 ou 2, caractérisé en ce que la platine (2) comporte dans son logement ouvert (8) une zone centrale évidée, circulaire, de diamètre légèrement inférieur à celui du substrat, les butées fixes (9) étant constituées par des rebords solidaires de la platine et espacés de la périphérie de la zone centrale, ces rebords comportant chacun une première partie (10) perpendiculaire au plan de la platine et terminée par une seconde partie (11) dirigée vers le centre de la zone centrale pour s'étendre parallèlement au plan du substrat de telle sorte que celui-ci, lors de sa mise en place sur la platine soit disposé au-dessus de la zone centrale avec son bord engagé sous les rebords des butées fixes (9).

4 - Dispositif selon la revendication 3, caractérisé en ce que chaque rebord d'une butée fixe (9) délimite entre sa seconde partie parallèle au plan de la platine et celle-ci un espace dont la hauteur est sensiblement égale à l'épaisseur du substrat (12).

5 - Dispositif selon l'une quelconque des revendications 1 à 4, caractérisé en ce que la butée complémentaire (14) est constituée par un pion, comprenant un axe (16) et une tête plate (15) perpendiculaire à cet axe, l'évidement (18) de la platine (2) présentant des dimensions correspondant à celles de la tête du pion pour permettre d'effacer celui-ci dans l'épaisseur de la platine, l'axe du pion traversant librement un passage (19) communiquant avec l'évidement et étant soumis à l'effet d'un ressort (20) qui tend en permanence à exercer sur ce pion un effort repoussant le pion vers l'extérieur de l'évidement en direction du substrat (12).

6 - Dispositif selon la revendication 5, caractérisé en ce que l'axe (16) du pion (14) se termine par un épanouissement conique (17) évasé, ménagé à l'opposé de la tête plate (15) et contre lequel s'appui le ressort (20), immobilisé contre la platine dans une rainure ouverte (21) prévue dans celle-ci à l'extérieur de l'évidement recevant le pion.

7 - Dispositif selon l'une des revendications 5 ou 6, caractérisé en ce que le ressort (20) présente la forme d'une épingle à cheveux, dont une branche (22) est en appui dans le fond de la rainure (21) et l'autre (23) forme une boucle entourant l'axe (16) du pion (14).

8 - Dispositif selon l'une quelconque des revendications 1 à 7, caractérisé en ce que la platine (2) est montée sur une embase fixe (7) et bloquée sur celle-ci au moyen d'un ensemble de verrouillage (4-6), notamment du genre à baïonnette.

FIG. 1

FIG. 2

FIG. 3

FIG. 4

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int. Cl.5) |
|---|---|---|---|
| A | US-A-4 473 455  (DEAN et al.) * Figures 4-8; colonne 4, ligne 67 - colonne 5, ligne 29 * --- | 1,2 | C 30 B  25/12 C 30 B  23/02 C 23 C  14/50 |
| A | PATENT ABSTRACTS OF JAPAN, vol. 7, no. 204 (E-197)[1349], 9 septembre 1983; & JP-A-58 102 525 (NIPPON DENKI K.K.) 18-06-1983 * Résumé * --- | 1,8 | |
| A | PATENT ABSTRACTS OF JAPAN, vol. 12, no. 306 (C-522)[3153], 19 août 1988; & JP-A-63 79 964 (ULVAC CORP.) 09-04-1988 --- | | |
| A | FR-A-2 571 746   (COMPAGNIE GENERALE D'ELECTRICITE) ----- | | |

| DOMAINES TECHNIQUES RECHERCHES (Int. Cl.5) |
|---|
| C 23 C C 30 B |

Le présent rapport a été établi pour toutes les revendications

| Lieu de la recherche | Date d'achèvement de la recherche | Examinateur |
|---|---|---|
| LA HAYE | 02-10-1989 | COOK S.D. |

EPO FORM 1503 03.82 (P0402)